# EUROPÄISCHE PATENTSCHRIFT

(11) **EP 0 458 222 B1**
(45) Veröffentlichungstag und Bekanntmachung des Hinweises auf die Patenterteilung: **27.03.1996**
(21) Anmeldenummer: 91108069.5
(22) Anmeldetag: 18.05.1991
(51) Int. Cl.: H01J 37/248

(54) **Hochspannungsdurchführung für Korpuskularstrahlgeräte**
High voltage lead-through for corpuscular ray device
Borne de traversée à haute tension pour dispositif de rayons corpusculaires

(30) Priorität: 23.05.1990 DE 4016556
(43) Veröffentlichungstag der Anmeldung: 27.11.1991
(73) Patentinhaber: Firma Carl Zeiss, D-73446 Oberkochen (DE)
(72) Erfinder: Hoffmeister, Dietrich, W-7082 Oberkochen (DE); Bihr, Johannes, W-7080 Aalen (DE); Niebel, Harald, W-7082 Oberkochen (DE)

(56) Entgegenhaltungen:
- DE-C- 3 029 624
- US-A- 3 042 828
- US-A- 3 601 649
- US-A- 3 636 346
- US-A- 4 051 405
- ZEITSCHRIFT FüR ANGEWANDTE PHYSIK, Band 15, Heft 6, 1963, Springer-Verlag, Berlin, HANS BOERSCH et al.: "Oberflächenentladungen über Isolatoren im Vakum"

## Beschreibung

Die vorliegende Erfindung betrifft eine Hochspannungsdurchführung zum Einführen einer Hochspannung in ein Vakuum, insbesondere für Korpuskularstrahlgeräte, bestehend aus einer Hochspannungselektrode, einem die Hochspannungselektrode umschließenden Isolator mit einer an das Vakuum grenzenden Oberfläche und aus einer den Isolator umschließenden Außenelektrode auf einem niedrigeren Potential.

Zu den Korpuskularstrahlgeräten gehören bekanntlich Elektronen- und Ionenmikroskope, sowie Elektronenstrahlgeräte.

Bei Elektronenmikroskopen und Elektronenstrahlgeräten hat die Kathode ein hohes negatives Potential, das gegenüber dem Gehäuse, welches auf Erdpotential liegt, genügend gut isoliert sein muß. Wegen der großen Potentialdifferenz kommt dabei der Ausbildung der Hochspannungsdurchführung mit ihrem Isolator besondere Bedeutung zu.

Aus der DE-A-30 29 624 ist eine Hochspannungsdurchführung bekannt, bei der die an das Vakuum grenzende Oberfläche des Isolators im Anfang einer stufenartigen Vergrößerung der Hochspannungselektrode ansetzt und mit letzterer einen Winkel bildet, der ungefähr halb so groß ist wie der Winkel zwischen den die stufenartige Vergrößerung bildenden Teilen der Hochspannungselektrode am Anfang der stufenartigen Vergrößerung. Auf diese Weise wurde eine günstigere Potentialverteilung auf der an das Vakuum grenzenden Oberfläche des Isolators erreicht und dadurch die Entstehung von sog. Mikroentladungen auf der Isolatoroberfläche unterbunden.

Die auf diese Weise erreichten Verbesserungen erfüllen die weiter gestiegenen Anforderungen an Hochleistungs-Elektronenmikroskope nicht mehr in ausreichendem Maß, insbesondere bei den heute zur Erreichung hoher Auflösungsvermögen verwendeten größeren Hochspannungen. Die gestiegenen Anforderungen könnten durch größere Abstände und damit größere Gehäuseabmessungen erfüllt werden. Damit würde jedoch der Aufwand und der Platzbedarf zu stark ansteigen.

In der US-A-4,051,405 ist eine Elektronenquelle beschrieben, bei der eine mit dem Anodenträger leitend verbundene Erdungsplatte in das Vakuum hineinragende Vorsprünge aufweist. Welchem Zweck derartige Vorsprünge dienen sollen, ist der Schrift jedoch nicht entnehmbar.

Der vorliegenden Erfindung liegt die Aufgabe zugrunde, die bekannte Hochspannungsdurchführung so zu verbessern, daß sie auch für größere Hochspannungen geeignet ist ohne dabei ihre räumlichen Abmessungen erheblich zu vergrößern.

Die gestellte Aufgabe wird erfindungsgemäß dadurch gelöst, daß die Elektroden so ausgebildet sind, daß in den Tripelbereichen, in welchen die an das Vakuum grenzende Oberfläche des Isolators einen Abstand von einer der Elektroden bis zu ca. 1/10 des Elektrodenabstandes in Richtung der an das Vakuum grenzenden Oberfläche des Isolators hat, mit guter Näherung noch das Potential der betreffenden Elektrode besteht.

Die Bereiche, in dem die an das Vakuum grenzenden Oberfläche des Isolators einen Abstand von einer Elektrode bis ca. 1/2 cm hat, kann man als Tripelbereiche bezeichnen, weil hier Vakuum, Isolator und Elektrode sehr dicht beieinander liegen. Die erfindungsgemäße Lösung liegt also darin, beiden Elektroden eine solche Form zu geben, daß die Tripelbereiche in Bereichen liegen, welche mit guter Näherung noch das Potential der Elektroden haben. Dadurch ist in diesen Bereichen die elektrische Feldstärke minimal, so daß es an diesen kritischen Stellen der Isolatorfläche zu keinen Mikroentladungen kommt.

Der Feldstärkenverlauf an der Isolatoroberfläche kann für vorgegebene Elektrodenformen nach dem Liebmann'schen Maschenverfahren numerisch berechnet werden, welches z.B. in dem Buch von P. W. Hawkes, Magnetic

Elektron Lenses, Springer 1982, auf Seite 64 mit weiteren Literaturangaben beschrieben ist.

In einer bevorzugten Ausführungsform der Erfindung haben die Elektroden Vertiefungen, in denen die Tripelbereiche liegen.

In einer anderen Ausführungsform haben die Elektroden Erhöhungen, zwischen denen die Tripelbereiche liegen.

In einer weiteren Ausführungsform liegen die Tripelbereiche zwischen leitenden Teilen, z.B. Ringen, welche die Elektroden in einem Abstand bis zu ca. zwei Zentimetern umgeben und mit den Elektroden elektrisch verbunden sind.

In einer zweckmäßigen Ausgestaltung der Erfindung besteht der dem Vakuum zugekehrte Teil des Isolators aus einem gefüllten Gießharz und der andere Teil aus einer flexiblen, wärmeleitfähigen Silikonvergußmasse.

In einer anderen vorteilhaften Ausgestaltung besteht der dem Vakuum zugekehrte Teil des Isolators aus einem Keramikteil.

Aus herstellungstechnischen Gründen ist es zweckmäßig, mindestens die Außenelektrode aus wenigstens zwei Teilen zusammenzusetzen.

Weitere vorteilhafte Ausgestaltungen der Erfindung gehen aus den Unteransprüchen un den Erläuterungen zu den Figuren hervor.

Die Erfindung wird im folgenden anhand von in den Figuren 1 bis 4 dargestellten Ausführungsbeispielen näher erläutert. Dabei zeigen:
- Figur 1: eine Ausführung mit Vertiefungen in den Elektroden;
- Figur 2: eine Ausführung mit Erhöhungen auf den Elektroden und leitenden Teilen vor den Elektroden;
- Figur 3: eine Ausführung, bei welcher der dem Vakuum zugekehrte Teil des Isolators aus Keramik ist, und
- Figur 4: eine Ausführung, bei welcher das Keramikteil des Isolators durch metallische Verbindungen mit den Elektroden vakuumdicht verbunden ist.

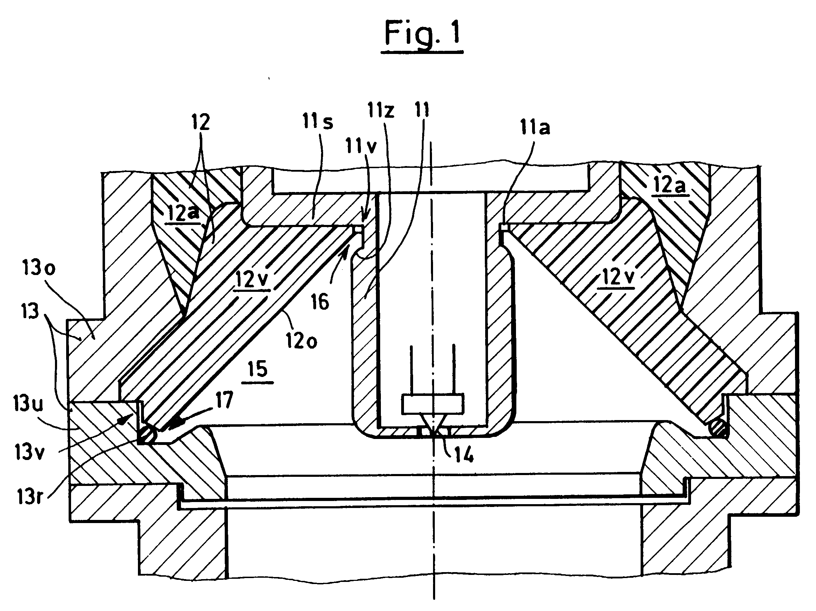

In Figur 1 ist ein Ausschnitt aus dem Kathodenkopf eines Elektronenmikroskopes dargestellt. Mit (11) ist eine Hochspannungselektrode bezeichnet, die auch Wehnelt-Elektrode genannt wird. Sie ist von der Außenelektrode (13) durch den Isolator (12) getrennt. Die Außenelektrode (13) liegt auf einem niedrigeren Potential als die Hochspannungselektrode, vorzugsweise auf Erdpotential. Mit (14) ist schematisch die Kathode eines Elektronenstrahlerzeugungssystems angedeutet, die annähernd auf demselben Potential wie die Hochspannungselektrode (11) liegt.

Die Hochspannungselektrode (11) hat die aus der oben zitierten Patentschrift bekannte stufenartige Vergrößerung (11s). Die an das Vakuum (15) grenzende Oberfläche (12o) des Isolators (12) beginnt ungefähr im Anfang (11a) der stufenartigen Vergrößerung (11s) und hat aus herstellungstechnischen Gründen kein spitzwinkliges Ende. Im Unterschied zur zitierten Patentschrift hat die Hochspannungselektrode (11) noch eine zweite stufenartige Vergrößerung (11z), deren Oberfläche vorzugsweise parallel zur Isolatoroberfläche (12o) läuft. Dies muß jedoch nicht der Fall sein, entscheidend ist, daß an der Außenfläche der Hochspannungselektrode (11) eine Vertiefung (11v) vorhanden ist, innerhalb derer die Isolatoroberfläche (12o) an der Elektrode endet.

Der Unterschied zum aus der zitierten Patentschrift bekannten Stand der Technik mag klein erscheinen; er hat jedoch eine erhebliche Wirkung: Durch die Weiterbildung der Stufe in eine Vertiefung besteht in dem Bereich, in welchem die an das Vakuum (15) grenzende Oberfläche (12o) des Isolators (12) einen Abstand von der Elektrode (11) bis zu ca. einem Zehntel des Elektrodenabstandes in Richtung der Oberfläche (12o) hat, mit guter Näherung noch das Potential der Elektrode (11). Damit wird in dem Tripelbereich (16), d.h. in jenem Bereich, in dem Isolator, Elektrode und Vakuum sehr dicht beieinander liegen und der daher für die Entstehung von Mikroentladungen besonders kritisch ist, die Entstehung von Mikroentladungen bis zu einer erheblich größeren Hochspannung als bei einer reinen Stufe unterbunden.

Die an der Hochspannungselektrode (11) erreichte Verbesserung muß durch entsprechende Maßnahmen an der Außenelektrode (13) ergänzt werden, damit die Hochspannungsdurchführung insgesamt bessere Eigenschaften erhält. Hierfür ist in Figur 1 die Außenelektrode (13) ebenfalls, mit einer Vertiefung (13v) ausgebildet, in welche die an das Vakuum (15) grenzende Oberfläche (12o) des Isolators (12) hineinreicht, so daß die an der Außenelektrode liegende Tripelbereich (17) ebenfalls in einem Bereich liegt, in dem mit guter Näherung noch das Potential der Außenelektrode (13) besteht.

Aus hertellungstechnischen Gründen besteht die Außenelektrode (13) aus mehreren Teilen (13o, 13u), deren Dimensionierung ebenso wie beim Außenbereich des Isolators (12) der Tatsache Rechnung trägt, daß sie dem vollen Athmosphärendruck ausgesetzt sind.

Der Isolator (12) besteht in seinem unteren, dem Vakuum zugekehrten Teil (12v) aus gefülltem Gießharz, damit eine ausreichende Festigkeit erreicht wird. Für den anderen, oberen Teil (12a) wird eine flexible, wärmeleitende Vergußmasse, z.B. Silikon verwendet. Diese geht mit dem unteren Teil (12v), dem (nicht gezeichneten) Hochspannungskabel, dem Gehäuse und den Anschlußteilen eine innige Verbindung ein, durch welche die Spannungsfestigkeit des unteren Teiles (12v) erreicht wird. Das Hochspannungskabel selbst wird ringförmig oberhalb der stufenförmigen Vergrößerung (11s) mit dem gleichen Durchmesser wie diese eingegossen und trägt so zu einer übersichtlichen Potentialführung bei.

Durch die Wärmeleitfähigkeit des oberen Teiles (12a) vom Isolator (12) wird die Wärme von der geheizten Kathode abgeführt. Durch seine Elastizität werden mechanische Spannungen infolge unterschiedlicher Wärmeausdehnungskoeffizienten gering gehalten. Der Rundschnurring (13r) dient zur Vakuumdichtung zwischen dem Isolatorteil (12v) und der aus den Teilen (13o) und (13u) zusammengesetzten Außenelektrode (13).

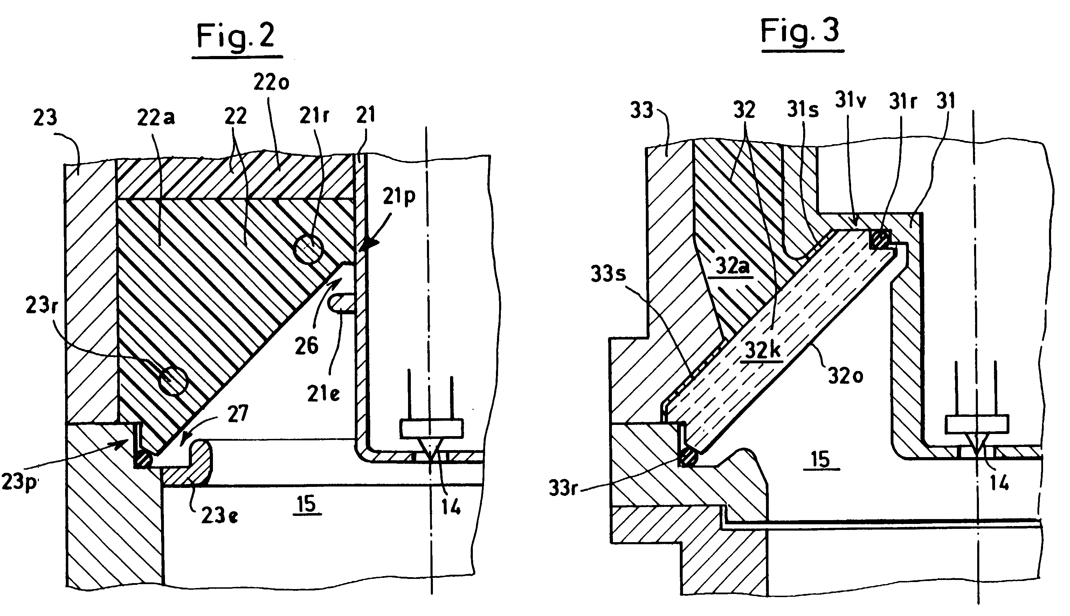

In Figur 2 ist eine andere Ausführungsform der Erfindung dargestellt, bei welcher ein Isolator (22) verwendet wird, der ebenfalls aus zwei Teilen (22o, 22u) besteht. Hier werden die Bereiche (21p, 23p), in denen mit guter Näherung noch die Potentiale der Elektroden (21, 23) bestehen und in denen die Tripelbereiche (26, 27) angeordnet sind, dadurch erreicht, daß die Elektroden (21, 23) Erhöhungen (21e, 23e) haben und/oder daß leitende Teile, z.B. Ringe (21r, 23r), die Elektroden (21, 23) in einem Abstand von bis zu 2 cm umgeben und mit ihnen elektrisch verbunden sind.

Es ist selbstverständlich auch möglich, Ringe im Vakuum (15) und/oder Erhöhungen im Isolator (22) anzuordnen. Ebenso ist es möglich, zusätzliche Ringe mit Zwischenpotentialen zu verwenden, um an der Isolatoroberfläche einen bestimmten Potentialverlauf zu erreichen.

Figur 3 zeigt ein Ausführungsbeispiel, bei dem der an das Vakuum (15) grenzende Teil des Isolators (32) aus einem Keramikteil (32k) besteht, dessen Oberfläche (32o) sehr gute vakuumtechnische Eigenschaften hat. Der obere Teil (32a) des Isolators (32) ist wieder aus einer flexiblen, wärmeleitenden Vergußmasse, die auch noch die Spalten (31s, 33s) zwischen dem Keramikteil und den Elektroden (31, 33) ausfüllt. Zur einwandfreien Vakuumdichtung dienen die Rundschnurringe (31r) und (33r). Dieses Ausführungsbeispiel zeigt auch, daß die Vertiefung in der Hochspannungselektrode (31) auch als deutlich ausgeprägte Vertiefung (31v) ausgeführt werden kann.

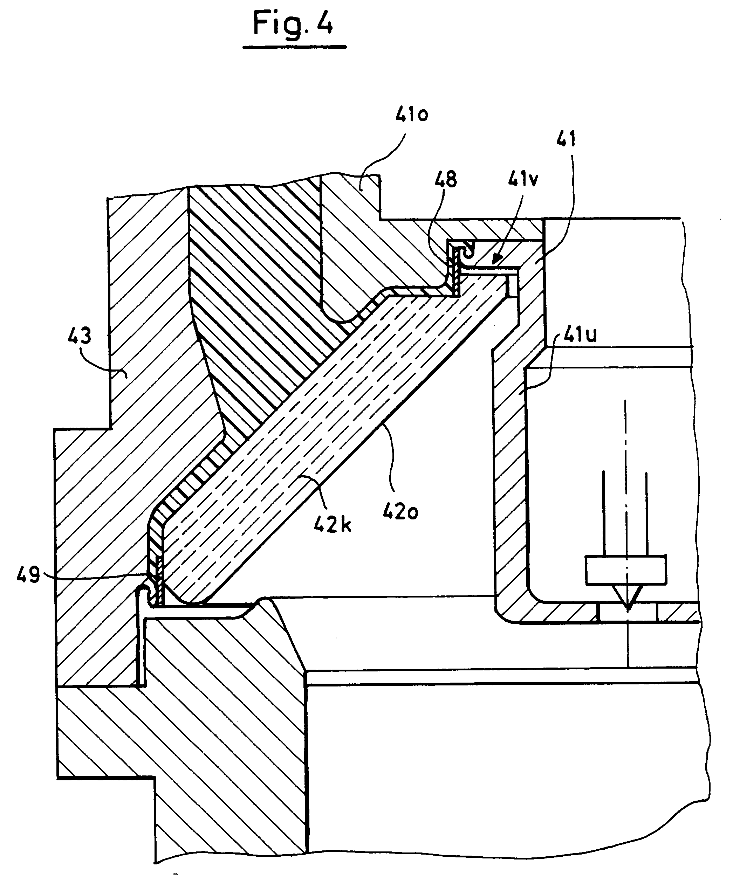

In der Figur 4 erfolgt die Vakuumdichtung zwischen dem Keramikteil (42k) und den Elektroden (41, 43) durch Metallrohrstücke (48, 49), die in bekannter Technik an das Keramikteil (42k) hart angelötet und anschließend mit den Elektroden (41, 43) verschweißt sind. Nach der Verschweißung wird an den unteren Teil (41u) der Hochspannungselektrode ihr oberer Teil (41o) angeschraubt und beide zusammen ergeben die Vertiefung (41v), welche mit guter Näherung das gleiche Potential wie die gesamte Elektrode hat und in welche die Oberfläche (42o) des Keramikteils (42k) hineinreicht.

Es ist üblich, Hochspannungselektrode, Isolator und Außenelektrode im wesentlichen rotationssymmetrisch auszubilden, weil dies für die Herstellung günstig ist. Dies ist jedoch nicht notwendig; die beschriebenen Eigenschaften lassen sich auch mit ovalen oder vieleckigen Ausführungsformen erreichen.

## Patentansprüche

1. Hochspannungsdurchführung zum Einführen einer Hochspannung in ein Vakuum, insbesondere für Korpuskularstrahlgeräte, bestehend aus einer Hochspannungselektrode (11), einem die Hochspannungselektrode umschließenden Isolator (12) mit einer an das Vakuum (15) grenzenden Oberfläche (12o) und aus einer den Isolator umschließenden Außenelektrode (13) auf einem niedrigeren Potential, dadurch gekennzeichnet, daß die Elektroden (11, 13) so ausgebildet sind, daß in den Tripelbereichen (16, 17), in welchen die an das Vakuum (15) grenzende Oberfläche (12o) des Isolators (12) einen Abstand von einer der Elektroden (11, 13) bis zu ca. 1/10 des Elektrodenabstandes in Richtung der an das Vakuum grenzenden Oberfläche (120) des Isolators hat, mit guter Näherung noch das Potential der betreffenden Elektrode (11, 13) besteht.

2. Hochspannungsdurchführung nach Anspruch 1, dadurch gekennzeichnet, daß die Elektroden (11, 13) mit Vertiefungen (11v, 13v) ausgebildet sind, in denen die Tripelbereiche (11, 13) liegen.

3. Hochspannungsdurchführung nach Anspruch 1, dadurch gekennzeichnet, daß die Elektroden (21, 23) mit Erhöhungen (21e, 23e) zur Bildung der Tripelbereiche (26, 27) ausgebildet sind.

4. Hochspannungsdurchführung nach Anspruch 1, dadurch gekennzeichnet, daß im Abstand von bis zu 2 cm vor dem Isolator an den Elektroden (21, 23) leitende Teile vorzugsweise Ringe (21r, 23r) angeordnet und mit den Elektroden (21, 23) elektrisch verbunden sind.

5. Hochspannungsdurchführung nach einem der Ansprüche 1 bis 4, dadurch gekennzeichnet, daß der dem Vakuum (15) zugekehrte Teil (12v) des Isolators (12) aus einem gefüllten Gießharz und der andere Teil (12a) aus einer flexiblen, wärmeleitfähigen Silikonvergußmasse besteht.

6. Hochspannungsdurchführung nach einem der Ansprüche 1 bis 4, dadurch gekennzeichnet, daß der dem Vakuum (15) zugekehrte Teil des Isolators (32) aus einem Keramikteil (32k) und der andere Teil (32a) aus einer flexiblen, wärmeleitfähigen Silikonvergußmasse besteht.

7. Hochspannungsdurchführung nach einem der Ansprüche 1 bis 6, dadurch gekennzeichnet, daß die Außenelektrode (13) aus mehreren Teilen (13o, 13u) zusammengesetzt ist.

8. Hochspannungsdurchführung nach einem der Ansprüche 1 bis 7, dadurch gekennzeichnet, daß die Hochspannungselektrode (41) aus mehreren Teilen (41o, 41u) zusammengesetzt ist.

9. Hochspannungsdurchführung nach einem der Ansprüche 1 bis 8, dadurch gekennzeichnet, daß zwischen der an das Vakuum (15) grenzenden Oberfläche (12o) des Isolators (12) und der Außenelektrode (13) ein Rundschnurring (13r) angeordnet ist.

10. Hochspannungsdurchführung nach einem der Ansprüche 6 bis 8, dadurch gekennzeichnet, daß das Keramikteil (42k) über Metallrohrstücke (48, 49) durch Löt- und/oder Schweißverbindungen mit den Elektroden (41u, 43) vakuumdicht verbunden ist.

## Claims

1. High-voltage lead-through arrangement for introducing a high-voltage into a vacuum, especially for a particle beam apparatus, comprising a high voltage electrode (11), an insulator surrounding the high-voltage electrode and having a surface (120) adjoining to the vacuum (15), and an outer electrode (13) having a lower voltage and surrounding the insulator, characterized in that the electrodes (11, 13) are configured such that in the triple regions (16, 17) in which the surface (12o) of the insulator (12) adjoining to the vacuum (15) has a distance from one of the electrodes (11, 13) up until about 1/10 of the electrode distance in the direction of the surface (12o) of the insulator adjoining to the vacuum, the voltage of the respective electrode (11, 13) is maintained in good approximation.

2. High-voltage lead-through arrangement of claim 1, characterized in that the electrodes (11, 13) are configured with recesses (11b, 13b) in which the triple regions (11, 13) are formed.

3. High-voltage lead-through arrangement of claim 1, characterized in that the electrodes (21, 23) are configured with projections (21e, 23e) for forming the triple regions (26, 27).

4. High-voltage lead-through arrangement of claim 1, characterized in that in a distance up until 2 cm in front of the insulator electrically conducting components, preferably rings (21r, 23r), are provided at and electrically connected to the electrodes (21, 23).

5. High-voltage lead-through arrangement of one of the claims 1 to 4, characterized in that the portion (12v) of the insulator (12) facing to the vacuum (15) is made of a filled cast resin and the other portion (12a) is made of a flexible, heat-conductive silicon cast mass.

6. High-voltage lead-through arrangement of one of the claims 1 to 4, characterized in that the portion of the insulator (32) facing to the vacuum (15) is made of a ceramic component (32k) and the other portion (32a) is made of a flexible heat-conductive silicon cast mass.

7. High-voltage leads-through arrangement of one of the claims 1 to 6, characterized in that the outer electrode (13) is assembled from a plurality of components (13o, 13u).

8. High-voltage lead-through arrangement of one of the claims 1 to 7, characterized in that the high-voltage electrode (41) is assembled of a plurality of components (41o, 41u).

9. High-voltage lead-through arrangement of one of the claims 1 to 8, characterized in that a sealing ring (13a) is provided between the surface (12o) of the insulator (12) adjoining to the vacuum (15) and the outer electrode (13).

10. High-voltage lead-through arrangement of one of the claims 6 to 8, characterized in that the ceramic component (42k) is connected to the electrodes (41u, 43) in vacuum tight manner by soldering or welding via tubular pieces (48, 49) made of metal.

## Revendications

1. Traversée de haute tension pour introduire une tension élevée dans un vide, notamment dans des appareils émettant un faisceau corpusculaire, composée d'une électrode de haute tension (11), d'un isolant (12) qui enveloppe l'électrode de haute tension et dont une surface (12o) confine le vide (15), ainsi que d'une électrode externe (13) de faible voltage qui entoure l'isolant, caractérisée en ce que les électrodes (11, 13) sont façonnées de manière à ce que le potentiel respectif de l'électrode (11, 13) persiste pour ainsi dire dans les zones triples (16, 17) où la surface (12o) de l'isolant (12) limitrophe du vide (15) est écartée de l'une des électrodes (11, 13) au maximum d'un dizième environ de la distance comprise entre les deux électrodes en direction de la surface limitrophe du vide (12o) de l'isolant.

2. Traversée de haute tension selon la revendication 1, caractérisée en ce que les électrodes (11, 13) sont façonnées pour présenter des cavités (11v, 13v) qui circonscrivent les zones triples (11, 13).

3. Traversée de haute tension selon la revendication 1, caractérisée en ce que les électrodes (11, 13) sont façonnées pour présenter des épaulements (21e, 13e) qui décrivent les zones triples (26, 27).

4. Traversée de haute tension selon la revendication 1, caractérisée en ce que des pièces conductrices, de préférence des anneaux (21r, 23r), sont disposées à une distance maximale de 2 cm en face de l'isolant sur les électrodes (21, 23) et sont reliées électriquement auxdites électrodes (21, 23).

5. Traversée de haute tension selon l'une des revendications énoncées de 1 à 4, caractérisée en ce que l'élément de l'isolant (32) adjacent au vide (15) est constitué d'une composante en céramique (32k) et d'une masse de colmatage (32a) thermoconductrice souple à base de silicone.

6. Traversée de haute tension selon l'une des revendications énoncées de 1 à 4, caractérisée en ce que l'élément (12v) de l'isolant (12) adjacent au vide (15) est rempli d'une résine de coulée (32k) et l'autre partie d'une masse de colmatage (12a) thermoconductrice souple à base de silicone.

7. Traversée de haute tension selon l'une des revendications énoncées de 1 à 6, caractérisée en ce que l'électrode externe (13) est composée de plusieurs parties (13o, 13u).

8. Traversée de haute tension selon l'une des revendications énoncées de 1 à 7, caractérisée en ce que l'électrode de haute tension (43) est composée de plusieurs parties (41o, 41u).

9. Traversée de haute tension selon l'une des revendications énoncées de 1 à 8, caractérisée en ce qu'un joint rond (13r) est aménagé entre la surface (12o) de l'isolant (12) limitrophe du vide (15) et l'électrode externe (13).

10. Traversée de haute tension selon l'une des revendications énoncées de 1 à 8, caractérisée en ce que la composante en céramique (42k) est reliée aux électrodes (41u, 43) par l'intermédiaire de raccords métalliques (48, 49) à l'aide de joints brasés etlou soudés hermétiques au vide.
